# EUROPÄISCHE PATENTSCHRIFT

(11) **EP 1 495 491 B1**
(45) Veröffentlichungstag und Bekanntmachung des Hinweises auf die Patenterteilung: **16.12.2020**
(21) Anmeldenummer: 03725032.1
(22) Anmeldetag: 15.04.2003
(51) Int. Cl.: H01L 21/50

(54) **VERFAHREN ZUM VERBINDEN VON SUBSTRATEN UND VERBUNDELEMENT**
METHOD FOR CONNECTING SUBSTRATES AND COMPOSITE ELEMENT
PROCÉDÉ DE LIAISON DE SUBSTRATS ET ÉLÉMENT COMPOSITE

(30) Priorität: 15.04.2002 DE 20205830 U; 23.05.2002 DE 10222958; 23.05.2002 DE 10222964; 23.05.2002 DE 10222609; 13.11.2002 DE 10252787; 16.01.2003 DE 10301559
(43) Veröffentlichungstag der Anmeldung: 12.01.2005
(73) Patentinhaber: Schott AG, 55122 Mainz (DE)
(72) Erfinder: MUND, Dietrich, 84101 Obersüssbach (DE); LEIB, Jürgen, 85354 Freising (DE)
(74) Vertreter: Herden, Andreas F.
(86) Internationale Anmeldenummer: PCT/EP2003/003907
(87) Internationale Veröffentlichungsnummer: WO 2003/088347

(56) Entgegenhaltungen:
- EP-A- 0 280 905
- WO-A1-95/20754
- US-A- 4 232 814
- US-A- 5 448 444
- US-A- 5 895 233
- WOO-BEOM CHOI ET AL: "Anodic bonding technique under low-temperature and low-voltage using evaporated glass" , VACUUM MICROELECTRONICS CONFERENCE, 1996. IVMC'96., 9TH INTERNATIONAL ST. PETERSBURG, RUSSIA 7-12 JULY 1996, NEW YORK, NY, USA,IEEE, US, PAGE(S) 427-430 XP010232226 ISBN: 0-7803-3594-5 das ganze Dokument
- ERNST, RICHARD: "Wörterbuch der Industriellen Technik, Band I", 1989, OSCAR BRANDSTETTER VERLAG GMBH & CO. KG, WIESBADEN, WIESBADEN * page 70 - page 71 *
- DROST A ET AL: "SIMULTANEOUS FABRICATION OF DIELECTRIC AND ELECTRICAL JOINTS BY WAFER BONDING", OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, vol. 3514, 21 September 1998 (1998-09-21), pages 62-71, XP009018435, DOI: 10.1117/12.323914 ISBN: 978-1-62841-730-2
- SASSEN S ET AL: "Anodic bonding of evaporated glass structured with lift-off technology for hermetical sealing", SENSORS AND ACTUATORS A: PHYSICAL, ELSEVIER BV, NL, vol. 83, no. 1-3, 1 May 2000 (2000-05-01), pages 150-155, XP004198307, ISSN: 0924-4247, DOI: 10.1016/S0924-4247(00)00300-9
- KO W H ET AL: "Touch mode capacitive pressure sensors for industrial applications", PROCEEDINGS / MEMS 97 : THE TENTH ANNUAL INTERNATIONAL WORKSHOP ON MICRO ELECTRO MECHANICAL SYSTEMS ; AN INVESTIGATION OF MICRO STRUCTURES, SENSORS, ACTUATORS, MACHINES AND ROBOTS, NAGOYA, JAPAN, JANUARY 26-30, IEEE SERVICE CENTER, PISCATAWAY, NJ, US, 26 January 1997 (1997-01-26), pages 284-289, XP010216919, DOI: 10.1109/MEMSYS.1997.581828 ISBN: 978-0-7803-3744-2
- Yong S. Lee ET AL: "A Batch-Fabricated Silicon Capacitive Pressure Transducer with Low Temperature Sensitivity", IEEE TRANSACTIONS ON ELECTRON DEVICES, 1 January 1982 (1982-01-01), pages 42-48, XP055526512, Retrieved from the Internet: URL:https://ieeexplore.ieee.org/document/1 482153 [retrieved on 2018-11-23]

## Beschreibung

### Art der Erfindung

Die Erfindung betrifft ein Verfahren zum Verbinden von Substraten im Allgemeinen und zum Verbinden von Substraten mit elektrischen, halbleitenden, mechanischen und/oder optischen Bauelementen sowie ein Verbundelement im Besonderen.

### Hintergrund der Erfindung

Verbindungstechniken finden für eine Vielzahl von technischen Bereichen Anwendung. Beispielhaft sei an dieser Stelle die Gehäusebildung für elektronische Bauelemente genannt, mittels welcher z.B. elektronische Schaltkreise eingeschlossen werden.

So sind Verfahren bekannt, bei denen Bauelemente oder integrierte Schaltungen auf einem Halbleiterchip oder noch im Verbund einer Halbleiterscheibe bzw. Wafers mit einem Gehäuse und mit elektrischen Anschlusskontakten versehen werden. Findet die Montage des Chips bzw. der integrierten Schaltung und die Verbindung der Kontaktgebiete des Chips mit den nach außen geführten Kontakten des Gehäuses noch im Waferverbund statt, so wird ein solches Montageverfahren im allgemeinen als "Wafer Level Packaging-Verfahren" bezeichnet. Bekannt ist auch eine Gehäusung von einzelnen Chips oder Dies, sogenanntes "Single-Die-Packaging".

Bei diesen Verfahren werden Bauteile, z.B. mit Epoxiden verklebt. Nachteilig beim Kleben ist jedoch eine geringe chemische Resistenz, schlechte optische Eigenschaften und die Gefahr der Verschmutzung von Bauteilen mit Klebstoff. Ferner unterliegen Klebstellen einem Alterungsprozess, was von einer Abnahme der Verbindungsqualität begleitet wird.

Zu den grundsätzlich bekannten Verbindungstechniken oder -verfahren gehört auch das sogenannte Bonden oder Bonding. Eine besondere Art des Bondens ist das sogenannte anodische Bonden, wobei an einer Grenzfläche unter Wärmebeaufschlagung eine Spannung angelegt und dadurch eine Ladungsträgerdiffusion forciert wird.

Wenngleich Bonding-Verfahren gegenüber epoxidischem Kleben eine Reihe von Vorteilen aufweisen, sind sie in ihrer Anwendung sehr beschränkt und daher unflexibel.

Nachteiliger Weise ist z.B. das anodische Bonden auf eine sehr eng begrenzte Anzahl von Materialien beschränkt, da die Ladungsträger in dem Material bereitgestellt werden müssen. So erfordert das anodische Bonden typischerweise z.B. alkalihaltige Materialien. Somit scheidet anodisches Bonden für eine Vielzahl von Anwendungen aus. Ähnliches gilt auch für andere Bonding-Verfahren.

Darüber hinaus tragen Bonding-Verfahren nicht auf, so dass sie sich bislang lediglich für planparallele Verbindungen eignen. Auch dies beschränkt den Anwendungsbereich erheblich.

Das Dokument EP 0 280 905 beschreibt ein Verfahren zum Herstellen von Drucksensoren, bei welchem eine Borosilikat-Glasschicht auf einem Siliziumwafer gebildet wird. Die Glasschicht ist als Matrix beschrieben, welche die entsprechenden Sensorchips und eine leitfähige Schicht bedeckt. Die Borosilikat-Glasschicht wird jedoch durch Sputtern auf der Oberfläche des Siliziumsensorwafers gebildet. Mittels Sputtern ist es grundsätzlich schwierig und aufwändig größere Schichtdicken zu erzeugen. Es wird zwar eine Schichtdicke von 5µm erwähnt, jedoch geht dies beim Sputtern typischerweise mit einer starken Erwärmung des Substrats einher, so dass hierdurch weitere Schwierigkeiten entstehen können.

Das Dokument US 5,825,233 beschreibt ein Mikrogehäuse für Infrarotchips, bei welchem eine Lötmittelschicht mittels Vakuum-Abscheidung und Lift-Off-Technik oder Ätzen oder mittels einer Maske aufgebracht wird. Ein Lötmittel bringt jedoch z.B. die Gefahr von Verunreinigungen mit sich.

Das Dokument "Anodic Bonding Technique under Low-temperature and Low-voltage using Evaporated Glass" von Woo-Beom Choi, 9th International Vacuum Microelectronics Conference, St. Petersburg 1996, beschreibt ein Verfahren, bei welchem eine Glasschicht mittels Elektronenstrahlverdampfung auf einem Siliziumwafer aufgebracht wird. Die Anwendung dieses Verfahrens ist jedoch begrenzt.

Das Dokument "Simultaneous fabrication of dielectric and electrical joints by wafer bonding" von Andreas Dorst et al., SPIE Conference on Micromachined Devices and Components IV, Santa Clara, September 1998 beschreibt die Herstellung mikromechanischer Systeme aus zwei oder mehr gestapelten Silikonteilen. Gemäß diesem Dokument weist anodisches Bonden mit einer Zwischenschicht aus Pyrex Glas verschiedene Vorteile bezüglich Flexibilität und Stabilität des Bonds. Zwecks Nutzung dieser Technologie wird der Prozess der

Sputterabscheidung von Pyrex Glas optimiert. Ferner wird der Prozess des anodischen Bondens dargestellt. Insbesondere wird der Prozess zur Herstellung eines kapazitiven Drucksensors entwickelt. Der Sensor umfasst Bondrahmen aus gesputtertem Glas. Der elektrische Kontakt zwischen den beiden Elektroden und Kontaktpads wird mit seitlichen und vertikalen Durchführungen realisiert. Diese Durchführungen werden mittels einer Au-Au Thermokompressionsbonds erhalten, der gleichzeitig mittels anodischem Bonden hergestellt wird.

Das Dokument "Anodic bonding of evaporated glass structured with lift-off technology for hermetical sealing" von S. Sassen et al., in Sensors and Actuators 83 (2000), 150 - 155 beschreibt eine verbesserte Technologie zum anodischen Bonden dünner, mittels e-Strahl aufgedampfter Glasschichten für Sensoren und Aktuatoren aus Silikon. Das hierbei genutzte Verfahren wird für das Bonding zwischen einem Silikonwafer mit elektrischen Strukturen und einem Silikonwafer als Hauptteil verwendet. Die Rahmenstruktur wird mit hermetisch abgedichteten Durchführungen aus Metall realisiert. Letztere sind insbesondere geeignet für kapazitive Sensoren mit einem schmalen Spalt und schnellen RC Zeitkonstanten. Zum Strukturieren des Glases wird eine Lift-Off Technologie eingesetzt, wobei Metall als Opferschicht genutzt wird, während ie Substrate auf etwa 300°C erhitzt werden, um die Qualität der Glasschicht zu erhöhen. Das Dokument bescheribt auch ein einfaches Modell für den Stromfluss während des Bonding-Prozesses.

Das Dokument "A Batch-Fabricated Silicon capacitive Pressure Transducer with Low Temperature Sensitivity" von Young S. Lee und Kensall D. Wise, IEEE Transactions on Electron Devices, Vol. ED-29, No.1, Januar 1982 zeigt die Herstellung eines kapazitiven Druckwandlers unter Verwendung von Silikon-Technologie für integrierte Schaltkreise. Die

Temperaturkoeffizienten werden als wesentlich niedriger beschrieben als die von monolithischen Geräten nach dem Stand der Technik.

Das Dokument "Touch Mode capacitive Pressure Sensors for Industrial Applications" von Wen H. Ko et al., Proceedings /Mems 97: International Workshop on micro electro mechanical Systems, an investigation of micro structures, Sensors, actuators, Machines and Robots, Nagoya, 26. - 30. Januar, IEEE Service Center, 26. Januar 1997, 284 - 289 beschreibt technische Hintergründe zu kapazitiven Drucksensoren.

Jedenfalls besteht nach wie vor ein großer Bedarf an vielseitigen und verbesserten Verbindungsverfahren.

Die Aufgabe der Erfindung wird in überraschend einfacher Weise bereits durch den Gegenstand der unabhängigen Ansprüche gelöst. Vorteilhafte Weiterbildungen der Erfindung sind in den Unteransprüchen definiert.

Erfindungsgemäß wird ein Verfahren zum Verbinden von zumindest zwei Substraten, mit elektrischen, halbleitenden, mechanischen und/oder optischen Bauelementen vorgeschlagen.

Die Substrate sind vorzugsweise aus einem Material oder Materialverbünden, welches bzw. welche Glas, Keramik oder Halbleitermaterialien, insbesondere Silizium, III-V wie GaAs bzw. GaAlₓAs₁₋ₓ (VCSELs), II-VI InP (LEDs), aber auch andere organische oder anorganische Materialien wie z.B. Metalle, z.B. Kovar umfasst. Insbesondere wird nach dem Bereitstellen eines ersten Substrats ein Verbindungselement in Form eines Rahmens aus Glas direkt auf einer ersten Oberfläche des ersten Substrats erzeugt, wobei Glas aufgedampft wird und das Verbindungselement sich beim Abscheiden mit dem ersten Substrat verbindet, und wobei auf der ersten Oberfläche des ersten Substrats Leiterbahnen angeordnet sind und das Verbindungselement derart auf die erste Oberfläche aufgedampft wird, dass die Leiterbahnen zumindest teilweise abgedeckt werden und sich die Leiterbahnen lateral oder vertikal durch das Verbindungselement hindurch erstrecken und hermetisch durch den Rahmen durchgeführt sind.

Anschließend werden nach einem Bereitstellen eines zweiten Substrats das erste und zweite Substrat mittels des Verbindungselements verbunden, wobei zwischen dem ersten und zweiten Substrat und innerhalb des Rahmens eine Kavität gebildet wird, welche hermetisch abgeschlossen ist, und wobei das erste oder zweite Substrat ein Glassubstrat ist. Insbesondere wird eine Oberfläche des zweiten Substrats mit einer Oberfläche des Verbindungselements temporär, z.B. als Schutz für weitere Bearbeitungsschritte oder dauerhaft verbunden. Auf diese Weise lässt sich in sehr einfacher Weise ein Verbundelement, z.B. ein hermetisch gekapselter oder gehäuster Chip oder "Die" ir "Single-Die-Technik" oder im Waferverbund, sogenanntes "Wafer-Level-Packaging" herstellen.

Beim "Wafer Level Packaging" sind das erste und zweite Substrat durch einen ersten bzw. zweiten Wafer realisiert. Auf der ersten Oberfläche des ersten Wafers wird um jeden Halbleiterbereich oder späteren Chip ein Rahmen aufgedampft, so dass eine Vielzahl von lateral benachbarten und/oder lateral beabstandeten Rahmen erzeugt werden. Nach dem Verbinden der beiden Wafer zu einem Waferverbund wird dieser zwischen den Rahmen in einzelne Chips zerteilt, insbesondere zersägt. Vorteilhafter Weise werden somit eine Vielzahl von Chips in einem Arbeitsschritt gleichzeitig gehäust.

Die Gehäusung eignet sich besonders für elektronische Bauelemente, insbesondere für Halbleiter, optische und/oder mikromechanische Systeme.

Die Anwendungsgebiete sind höchst vielfältig, so eignet sich das erfindungsgemäße Verfahren insbesondere zum Kapseln von mikro-elektromechanischen (MEMS), mikro-optischen (MOMS), mikro-elektromechanisch-optischen System (MOEMS) oder konventionellen Halbleiterbereichen oder -elementen auf einem der beiden zu verbindenden Substrate. Das Verbindungselement bildet bei dieser Anwendung z.B. einen, gegebenenfalls temporären, Anschlag für mikromechanische Bauelemente wie z.B. Mikroschalter oder Mikrospiegel.

Das Verbindungselement ist vorzugsweise ein Rahmen oder Bondrahmen, welcher auf der ersten Oberfläche eines der beiden Substrate abgeschieden wird und sich beim Abscheiden mit dem ersten Substrat dauerhaft und fest verbindet. Der Rahmen ist um seine Schichtdicke gegenüber der ersten Oberfläche des Substrats erhaben und stellt eine geeignete Bondfläche zur Verfügung.

Der Rahmen stellt dabei vollständig oder zumindest teilweise die Bondfläche zu einem oder mehreren weiteren Substraten bereit, insbesondere wenn der Rahmen mittels eines mehrstufigen Strukturierungsverfahrens aufgebracht wird.

Als besonders vorteilhaft hat es sich erwiesen, einen Rahmen aus Glas auf die erste Oberfläche abzuscheiden oder aufzudampfen. Als Glas wird insbesondere ein silikatisches oder borosilikatisches Glas, z.B. das Aufdampfglas 8329 und/oder G018-189 der Firma SCHOTT Glas verwendet. Ein Vorteil dieser Aufdampf- oder Beschichtungsverfahren ist das Aufbringen der isolierenden Glasschicht bei Raumtemperatur bis etwa 150°C, so dass keinerlei Schädigung oder Oxidation der Substratoberfläche auch bei Metallsubstraten zu erwarten ist.

Als Verbindungselement oder Rahmen wird also bevorzugt eine strukturierte Glasschicht verwendet, welche z.B. durch eine Maske aufgedampft und strukturiert wird. Zur Strukturierung haben sich fotolithografische Verfahren, z.B. mit einem Fotolack, insbesondere die sogenannte Lift-Off-Technik bewährt, welche dem Fachmann grundsätzlich bekannt ist.

Es können aber auch Masken verwendet werden, welche z.B. auf das Substrat aufgeklebt oder beim Aufdampfen zwischen Target und Substrat angeordnet sind.

Das erfindungsgemäße Verbindungselement, also die derart aufgedampfte Glasschicht als Rahmen weist eine Vielzahl von Vorteilen auf.

Zunächst besitzt Glas exzellente Eigenschaften hinsichtlich der Stabilität, Hermetizität und chemischen Widerstandsfähigkeit, insbesondere gegen Lösungsmittel, Säuren und Laugen. Diese Eigenschaften entsprechen einem Borosilikatglas.

Das Verbindungselement ist sehr genau in seiner lateralen Position, insbesondere wenn fotolithografische Strukturierungsverfahren zum Einsatz kommen.

Das Verbindungselement ist sehr genau in seiner lateralen Abmessung und in seiner Höhe aufdampfbar. Letzteres ist nach den Erkenntnissen der Erfinder sogar weitgehend unabhängig davon welches Strukturierungsverfahren angewandt wird. Ferner können die Verbindungselemente oder Rahmen kostengünstig im Verbund, z.B. auf Wafer-Level oder als Lose hergestellt werden.

Darüber hinaus ist das Verfahren sehr sauber und daher besonders tauglich z.B. für MEMS, wobei der Rahmen sogar unmittelbar auf das Substrat mit dem MEMS oder anderen Bauelement aufgedampft werden kann.

Die Herstellung des Rahmens, bzw. die Strukturierung der Glasschicht wird vorteilhaft bei niedrigen Temperaturen durchgeführt, so dass z.B. Lackmasken erhalten bleiben und mit einem Lösungsmittel, z.B. Aceton wieder abgelöst werden können. Damit ist das Verfahren auch für temperaturempfindliche Substrate, z.B. Kunststoffsubstrate oder organische Substrate geeignet.

Weiter wird das Erzeugen des Verbindungselements oder die Strukturierung der Glasschicht ohne aggressive Ätzgase und/oder Flüssigkeiten durchgeführt, so dass auch empfindliche Substrate verwendet werden können.

Zum Verbinden der beiden Substrate bzw. des zweiten Substrats mit dem Rahmen oder Bondrahmen eignen sich insbesondere die folgenden Techniken: Kleben, Löten und/oder Bonden.

Hieran wird der außergewöhnliche Vorzug der Erfindung deutlich. Sie ist nicht nur höchst vielseitig bezüglich der anwendbaren Verbindungstechniken, sondern es können sogar Substrate mittels des Verbindungselements z.B. anodisch gebondet werden, selbst wenn das Material eines oder beider Substrate selbst nicht anodisch bondbar ist, z.B. alkalifreies Glas wie AF45, AF37 oder AF32 der Firma SCHOTT Glas. Gegebenenfalls wird je ein Verbindungselement auf beide Substrate aufgebracht oder aufgedampft.

Zum anodischen Bonden wird ein Rahmen aus anodisch bondbarem Material, insbesondere umfassend ein alkalisches Glas verwendet. Dieser kann z.B. mittels sogenanntem Direct-Bonding auf das Glassubstrat mit Bondlayer mit diesem verbunden werden.

Alternativ zum anodischen Bonden eignet sich auch Fusion Bonding, Sol-Gel-Bonding und/oder Low-Temperature-Bonding. Diese Verfahren sind dem Fachmann grundsätzlich bekannt. Dennoch macht sich hieran ein weiterer Vorzug der Erfindung fest, da das Aufdampfmaterial oder Material des Bondrahmens unabhängig von dem Substratmaterial an das gewünschte Bondverfahren angepasst werden kann. Somit sind Substrate aus nahezu jedem Material mittels des oder der Verbindungselemente mit nahezu jedem Bondverfahren kombinierbar, wodurch vollkommen neue Anwendungfelder mit enormem Potential eröffnet werden.

Alternativ oder ergänzend wird die Oberfläche des Rahmens mit einer Metallisierung versehen und anschließend legierungs- oder weichgelötet. Gegebenenfalls wird die Bondfläche aktiviert.

Als Material für das erste und/oder zweite Substrat wird z.B. ein Wafer oder Chip aus einem Halbleitermaterial, z.B. Silizium, aus einem organischen Material, aus Glas, insbesondere ein silikatisches oder borosilikatisches Glas, z.B. Borofloat 33, aus Keramik oder aus Metall verwendet, wobei das erste oder zweite Substrat ein Glassubstrat ist.

Der Rahmen ist insbesondere geschlossen, z.B. ein Vieleck aus geraden oder gekrümmten Stegen, ein Kreis oder ein beliebiges anderes Gebilde und das zweite Substrat wird hermetisch dicht mit dem Rahmen fest und dauerhaft verbunden. Hierdurch entsteht eine hermetische Kapselung oder Gehäusung der Bereiche innerhalb des Rahmens, wobei das erste und zweite Substrat, insbesondere innerhalb des Rahmens, voneinander beabstandet sind, so dass ein Hohlraum oder eine Kavität gebildet wird. Es bleibt also zumindest ein Bereich innerhalb des Rahmens auf der Oberfläche des ersten Substrats frei von Rahmenmaterial.

Alternativ kann aber auch ein offener Rahmen mit Unterbrechungen der Stege aufgebracht werden, um eine Belüftung der Kavität zu erzielen.

Insbesondere wird die Dicke des Rahmens an die jeweilige Anwendung angepasst, wobei eine Kavität zwischen den beiden Substraten entsteht. Für die genannten Anwendungen haben sich Aufdampfdicken im Bereich von 100 µm bis 1 pm, vorzugsweise 10 µm bis 2 µm oder 4 µm erwiesen. Grundsätzlich sind Dicken von 1 mm bis 0,1 µm oder 10 nm erzielbar, bevorzugt sind insbesondere Dicken < 10 µm oder < 3 pm, es sind aber auch Dicken < 0,5 µm erreichbar.

Die Breite der Bondfläche kann sehr unterschiedlich sein, sie wird im Wesentlichen nur durch das erreichbare Aspektverhältnis der Maske für das Strukturierungsverfahren begrenzt. Breite Rahmen können bis hin zu mehreren Millimetern Stegbreite aufweisen oder sogar die gesamte Fläche des Substrats einnehmen.

Der Rahmen weist vorzugsweise eine Struktur- oder Stegbreite ≤ 10 mm, insbesondere ≤ 1 mm oder ≤ 100 pm, besonders bevorzugt von 1 µm bis 500 µm auf. In den Grenzfällen zu schmalen Rahmen sind Stegbreiten von < 100 nm oder sogar von wenigen 10 nm erreichbar. Im Vergleich z.B. zu einem einfach ausgeführten Siebdruck ist man nicht durch Korngrößen im Material beschränkt.

Erfindungsgemäß können mit der Lift-Off-Technik gute Aspektverhältnisse auch für Mikro-/Nanostrukturen, z.B. 3 µm / 2 µm = 3:2 mit einfachen Mitteln erzeugt werden. Es können folglich Aspektverhältnisse von > 1 oder ≥ 1,5 erzielt werden.

In vorteilhafter Weise lassen sich also mit dem erfindungsgemäßen Verfahren sehr schmale und dennoch relativ dicke oder hohe Rahmen erzeugen, sodass ein hinreichender Abstand zwischen den beiden Substraten bei gleichzeitiger lateraler Platzersparnis hergestellt wird.

Die Erfinder haben darüber hinaus festgestellt, dass sich schmale Rahmen besonders gut und hermetisch dicht bonden lassen. Andererseits wurde herausgefunden, dass für eine hermetische Gehäusung, gegebenenfalls mit einer kontrollierten Atmosphäre, bereits ein schmaler Rahmen oder Glasrahmen mit einer Stegbreite von 5 µm oder 10 µm bis 1000 µm eine wirkungsvolle Diffusionssperre für Gase, Feuchtigkeit und aggressive Medien bildet.

In der Kavität ist z.B. ein MEMS, MOMS, MOEMS und/oder ein Halbleiterbereich eines Siliziumchips oder -wafers angeordnet und gehäust oder hermetisch gekapselt.

Ergänzend kann vorgesehen sein, innerhalb des Rahmens ein oder mehrere Stützelemente, z.B. Stützpunkte oder -bereiche auf der ersten Oberfläche des ersten Substrats innerhalb des Rahmens anzuordnen, wobei dies vorzugsweise in dem selben Verfahrensschritt wie das Erzeugen des Rahmens durchgeführt wird. Die Stützelemente und/oder Rahmen umfassen geschlossene Rahmenformen, z.B. rund, mehr-eckig oder oval, aber auch Teile von Rahmenformen, z.B. Linien, Ecken, Rundungen, Punkte und wirken im Wesentlichen als Abstandshalter.

Vorzugsweise dient das obere Plateau des Bondsrahmens, also eine sich insbesondere zur Substratoberfläche im Wesentlichen parallel erstreckende Oberfläche des Aufdampfglases als Bondfläche. Hierbei hat der aufgebrachte Rahmen die Funktion einen vorbestimmten Abstand zwischen dem ersten Substrat und einem oder mehreren zweiten Substraten zu definieren.

Alternativ kann durch einen partiellen Rahmen auch ein genau vorbestimmter Neigungswinkel bei der Montage des zweiten Substrats gegenüber dem ersten Substrat erzielt werden. Ein geneigtes Design ist z.B. für Optokappen, sogenanntes "Einzel-VCSEL Packaging" vorteilhaft, um eine Teilreflexion des Lasers für die Monitordiode zu nutzen. Daher sind das erste und zweite Substrat in verbundenem Zustand insbesondere im Wesentlichen parallel oder geneigt zueinander.

Ferner alternativ kann auch eine Seitenwand des Rahmens als Bondfläche verwendet werden. Weiter ist es möglich, nicht planare Oberflächen mit Glas zu beschichten.

Gemäß einer besonders bevorzugten Weiterbildung der Erfindung werden mehrere Rahmen ineinander geschachtelt. Dies erhöht die Hermetizität und Sicherheit um ein Vielfaches.

Ferner kann innerhalb des Rahmens oder zwischen den ineinander geschachtelten Rahmen ein Klebstoff zum Verbinden eingebracht werden. Alternativ wird ein vorbestimmtes Fluid, also ein vorbestimmtes Gas, welches nicht Luft ist oder eine Flüssigkeit und/oder Partikel in die Kavität und/oder in den Zwischenraum zwischen den geschachtelten Rahmen eingebracht, bevor das erste und zweite Substrat verbunden werden. Das Fluid kann die Zwischenräume oder Kanäle durchströmen und eine Kühlflüssigkeit, eine sensorische Flüssigkeit, einen Farbfilter und/oder ein oder mehrere Reaktionsgase umfassen.

Der Rahmen weist vorzugsweise eine Mindestdicke auf, welche dafür sorgt, das sich die beiden Substrate und/oder darauf befindliche Bauelemente im gehäusten Zustand nicht berühren.

Gemäß einer besonders bevorzugten Ausführungsform der Erfindung sind auf einem der Substrate, z.B. dem ersten Substrat Leiterbahnen, z.B. zur Kontaktierung von Halbleiterelementen angeordnet.

Bevorzugt wird die Glasschicht in Form des Rahmens auf die Leiterbahnen aufgedampft, so dass diese zumindest bereichsweise hermetisch durch den Rahmen durchgeführt oder eingeschlossen sind. Bevorzugt bleibt ein Abschnitt der Leiterbahnen auf einer oder beiden Seiten des Steges frei, um später kontaktiert zu werden. Bevorzugt wird jeweils ein Steg oder Rand des Rahmens quer zu den Leiterbahnen aufgebracht. Nach dem Verbinden des Rahmens mit dem zweiten Substrat führen die Leiterbahnen somit hermetisch dicht durch den Rahmen von außen in die Kavität. Dabei können die Leiterbahnen nicht nur lateral, sondern auch vertikal zu dem ersten Substrat verlaufen und sich dergestalt durch das Verbindungselement hindurch erstrecken, so dass eine lateral oder vertikal verlaufende elektrische Verbindung durch die hermetische Kapselung hergestellt werden kann.

Gegebenenfalls wird der Rahmen nach dem Erzeugen auf der ersten Oberfläche des ersten Substrats oder genauer nach dem Aufdampfen, insbesondere abrasiv, mittels chemisch mechanischem Polieren oder einem anderen geeigneten Verfahren planarisiert. Dadurch werden vorteilhafter Weise Unebenheiten ausgeglichen, welche durch die Dicke der Leiterbahnen verursacht werden und somit ein gleichmäßiges Bonding erzielt.

Ferner können Justierelemente oder -hilfen auf der ersten oder einer zweiten Oberfläche des ersten Substrats erzeugt werden, wobei die zweite Oberfläche der ersten Oberfläche gegenüberliegt. Derartige Justierhilfen, z.B. in Form von Rahmen, Punkten und/oder Linien sind vorteilhaft für die Justage von Linsensystemen oder anderen optischen oder mechanischen Bauelementen.

Weiter wird vorzugsweise ein weiteres Verbindungselement auf der zweiten Oberfläche des ersten Substrats oder dessen Rückseite erzeugt, um eine Vielzahl von Substraten zu einem Stapel zu verbinden. Auch dies wird vorzugsweise vor dem Zerteilen oder "Dicing" durchgeführt und erhöht abermals den Durchsatz.

Im Folgenden wird die Erfindung anhand von Ausführungsbeispielen und unter Bezugnahme auf die Zeichnungen näher erläutert, wobei gleiche und ähnliche Elemente mit gleichen Bezugszeichen versehen sind und die Merkmale der verschiedenen Ausführungsbeispiele miteinander kombiniert werden können.

### Kurzbeschreibung der Figuren

Es zeigen:
- Fig. 1a-e: schematische Schnittdarstellungen der Herstellung eines Substratverbunds in verschiedenen Verfahrensstadien gemäß einem ersten Ausführungsbeispiel der Erfindung,
- Fig. 2: eine Draufsicht auf geschachtelte Bondrahmen auf einem Substrat gemäß einem zweiten Ausführungsbeispiel der Erfindung,
- Fig. 3: eine schematische Schnittdarstellung entlang der Linie A-A in Fig. 2,
- Fig. 4: eine Ausschnittsvergrößerung des Bereichs C in Fig. 3,
- Fig. 5: eine schematische Draufsicht auf geschachtelte Bondrahmen auf einem Substrat gemäß einem dritten Ausführungsbeispiel der Erfindung,
- Fig. 6: eine schematische Schnittdarstellung entlang der Linie D-D in Fig. 5,
- Fig. 7: eine schematische Draufsicht auf einen Wafer mit einer Vielzahl von Bondrahmen gemäß einem vierten Ausführungsbeispiel der Erfindung,
- Fig. 8a: eine Ausschnittsvergrößerung des Bereichs E in Fig. 7,
- Fig. 8b: wie Fig. 8a, jedoch mit aufgedampfter Glasschicht,
- Fig. 8c: wie Fig. 8b, jedoch nach Lift-Off,
- Fig. 9: eine schematische Schnittdarstellung eines Ausschnittes des vierten Ausführungsbeispiels nach dem Bonden,
- Fig. 10: eine schematische Draufsicht auf einen Ausschnitt eines Wafers mit überdampften Leiterbahnen gemäß einem fünften Ausführungsbeispiel der Erfindung,
- Fig. 11: eine Ausschnittsvergrößerung des Bereichs G in Fig. 10 in einer Schnittdarstellung entlang der Linie H-H,
- Fig. 12a: eine Ausschnittsvergrößerung des Bereichs G in Fig. 10 in einer Schnittdarstellung entlang der Linie K-K,
- Fig. 12b: wie Fig. 12a nach einem Planarisieren,

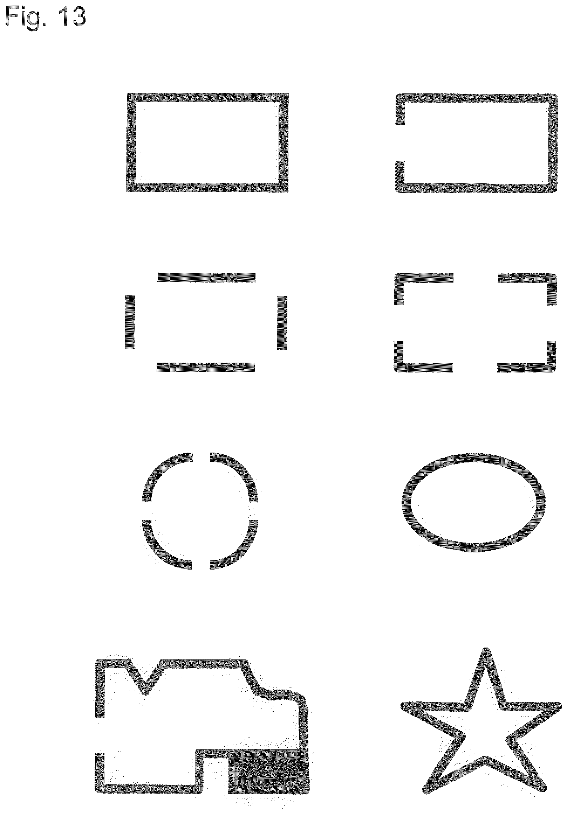

- Fig. 13: acht Beispiele für Formen des Bondrahmens,
- Fig. 14: Ergebnisse einer TOF-SIMS-Messung,
- Fig. 15: eine fotomikroskopische Aufnahme strukturierter Glasschichten,
- Fig. 16: eine fotomikroskopische Aufnahme eines sechsten Ausführungsbeispiels der Erfindung,
- Fig. 17: eine fotomikroskopische Aufnahme eines siebten Ausführungsbeispiels der Erfindung und
- Fig. 18: eine schematische Darstellung eines Wafers mit Lochmaske für einen Dichtigkeitstest.

### Detaillierte Beschreibung der Erfindung

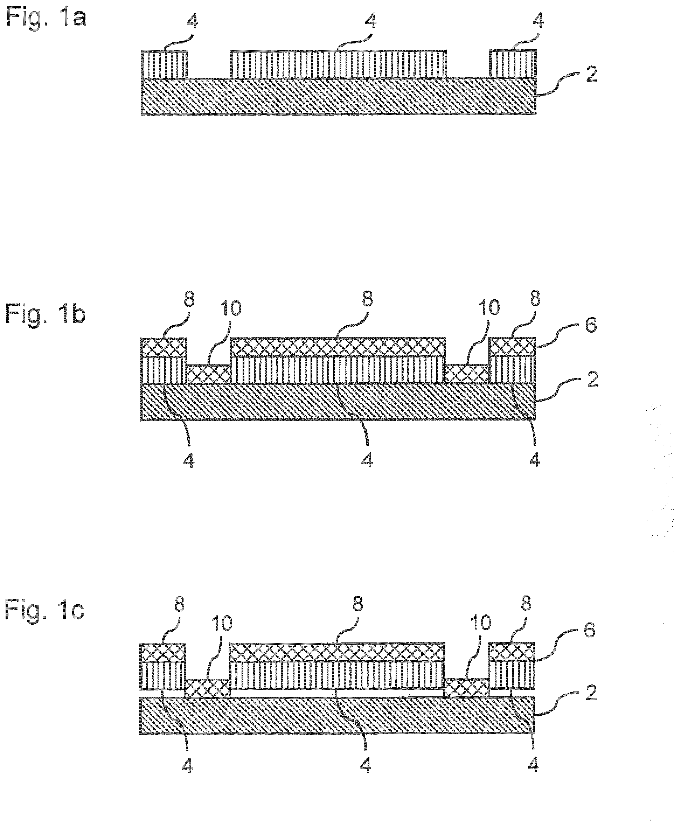

Fig. 1a zeigt ein Substrat 2 aus Metall. Alternativ kann das Substrat 2 auch ein Silizium-, Keramik- oder Glassubstrat sein. Auf das Substrat 2 ist ein Fotolack 4 mit einem dem Fachmann bekannten Verfahren aufgebracht und fotolithografisch strukturiert. In diesem Fall repräsentiert die Lackschicht eine auf dem Substrat fest haftende Maske. Alternativ kann auch eine nicht haftende Abdeckmaske oder Schattenmaske verwendet werden.

Bezugnehmend auf Fig. 1b wird anschließend eine geschlossene Glasschicht 6 aus dem Aufdampfglas 8329 auf das Substrat 2 und den Fotolack 4 aufgedampft.

Bezugnehmend auf Fig. 1c wird der Fotolack 4 mit den darauf befindlichen Abschnitten 8 der Glasschicht 6 mittels Aceton entfernt. Die Abschnitte 10 bleiben mit dem Metallsubstrat 2 fest verbunden. Dieses Verfahren wird als Lift-Off bezeichnet und ist dem Fachmann bekannt.

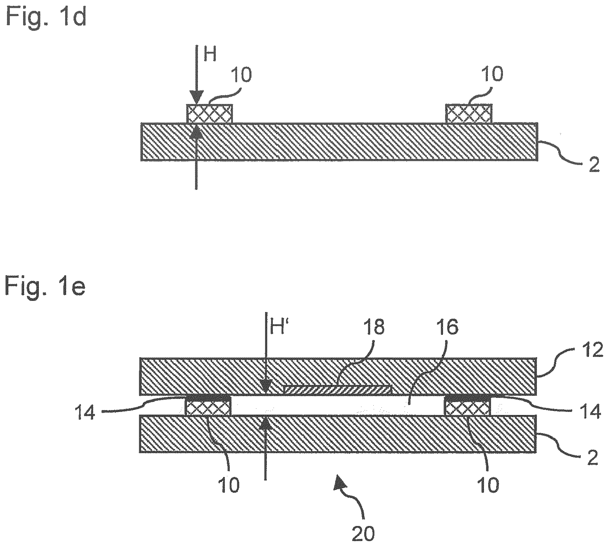

Bezugnehmend auf Fig. 1d verbleibt das Substrat 2 mit einer strukturierten Glasschicht in Form eines Bondrahmens 10.

Wie in Fig. 1e dargestellt ist, wird ein Decksubstrat 12 aus Silizium auf den Bondrahmen 10 anodisch gebondet, um ein Verbundelement 20 zu bilden, wobei die Bondstellen mit 14 bezeichnet sind. Aufgrund der Dicke oder Höhe H des Bondrahmens 10 ensteht eine Kavität 16 mit einer Höhe H', welche nicht wesentlich größer ist als H, so dass ein. Halbleiterbauelement 18 auf dem Decksubstrat 12 von dem Metallsubstrat 2 beabstandet ist.

Wieder Bezug nehmend auf Fig. 1b wird die Glasschicht 6 mittels Elektronenstrahlverdampfung aufgebracht. Dieses Verfahren ist zwar seit Jahren bekannt, wird aber bisher hauptsächlich zur mechanischen und optischen Vergütung von Kunststoff- oder Glas-Brillenlinsen verwendet, wobei lediglich flächige Schichten aufgetragen wurden.

Mit dem Aufdampfglas 8329 (entgastes Duran) sind hohe Aufdampfraten von bis zu 4 pm/min, insbesondere > 10 nm/min oder > 100 nm/min möglich. Besonders bevorzugt sind etwa 500 nm/min. Das übertrifft z.B. Sputterraten um ein Vielfaches und macht den Einsatz dieses Verfahrens für die erfindungsgemäße Anwendung äußerst interessant. Sputterschichten von Einkomponentensystemen, z.B. SiO₂ lassen sich nämlich lediglich mit Sputterraten von wenigen Nanometern pro Minute aufbringen.

Es werden folgende Parameter zum Aufbringen der geschlossenen Glasschicht 6 auf das Metallsubstrat 2 eingestellt:

| | |
|---|---|
| BIAS Temperatur während der Verdampfung: | 100°C |
| Druck während der Verdampfung: | 10⁻⁴ mbar |

Ferner wird ein Metallsubstrat 2 mit einer Oberflächenrauhigkeit < 50 µm verwendet und ein Aufdampfglas ausgewählt, dessen Temperaturausdehnungskoeffizient (CTE) moderat dilathermisch an das Metallsubstrat 2 und/oder an das Decksubstrat 12 angepasst ist. Das CTE des Glases 8239 beträgt 3,3 ppm/K, was etwa dem CTE von Silizium entspricht.

Aufgrund intensiver Versuche haben die Erfinder die Gläser 8329 oder G018-189 von SCHOTT Glas für Beschichtungen von Metall mit thermischer oder Elektronenstrahlverdampfung als besonders geeignet herausgefunden. Diese Aufdampfgläser zeigen eine sehr gute Beständigkeit gegen Lösungsmittel, Feuchte (85°, 85%, 1000h) und Temperatur (T<Tg). Die Gläser haben ferner sehr gute thermo-mechanische Eigenschaften, sogar bei tiefen Temperaturen (< -100°C), so dass eine Verwendung für supraleitende elektronische Bauelemente möglich erscheint. Andererseits sind die Gläser auch bei hohen Temperaturen (> 300°C) und daher insbesondere auch für Leistungselektronik, wie Power-CMOS-Bauelemente verwendbar.

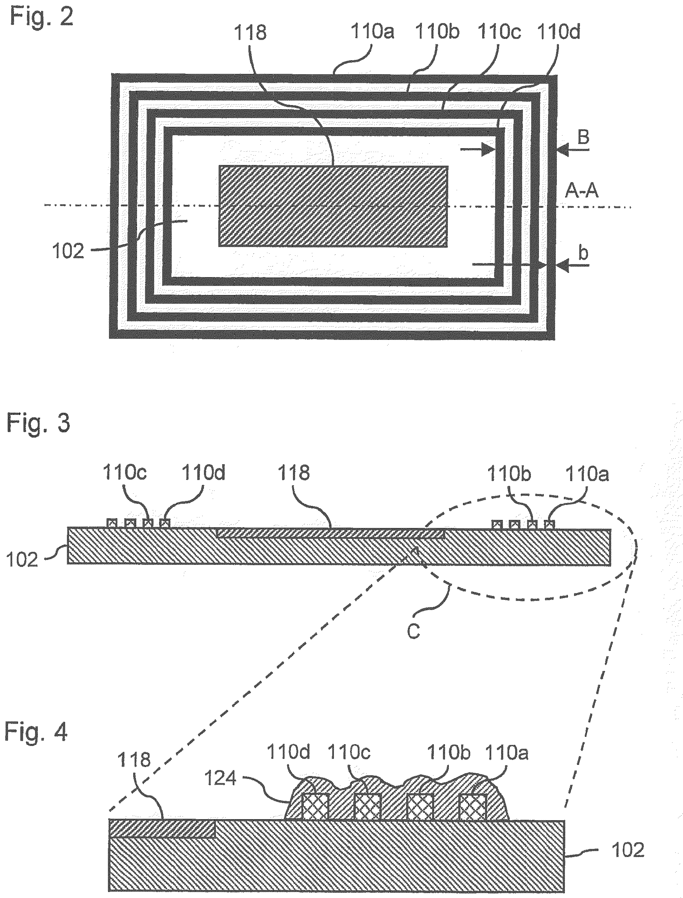

Die Fig. 2 und 3 zeigen eine Anordnung aus vier ineinander geschachtelten Bondrahmen 110a bis 110d, welche ein elektronisches Bauelement 118 auf einem Substrat 102 eingrenzen.

Bezugnehmend auf Fig. 4 wird ein Epoxid-Klebstoff 124 im Bereich der Rahmen 110a bis 110d aufgetragen, wobei die Oberfläche des Rahmens mit Klebstoff bedeckt und der Zwischenraum zwischen den Rahmen mit Klebstoff gefüllt ist. Hierdurch wird die Festigkeit der Verbindung erhöht. Ferner nehmen die Rahmen den Kleber besser auf und vereinfachen den Ablauf des Klebeprozesses.

Gegebenenfalls wird der Kleber unter Vakuum aufgebracht, um das Vollsaugen der Zwischenräume zu verbessern. Weiter dient die Mehrzahl an Rahmen als Crack-Stop zur Erhöhung der mechanischen Belastbarkeit des Verbundelements und zur Erhöhung der Zuverlässigkeit. Dabei ist die Mehrzahl der Rahmen mit jeweils einer kleineren Stegbreite b leichter und stabiler als ein einzelner massiver Rahmen von gleicher Summenstegbreite B.

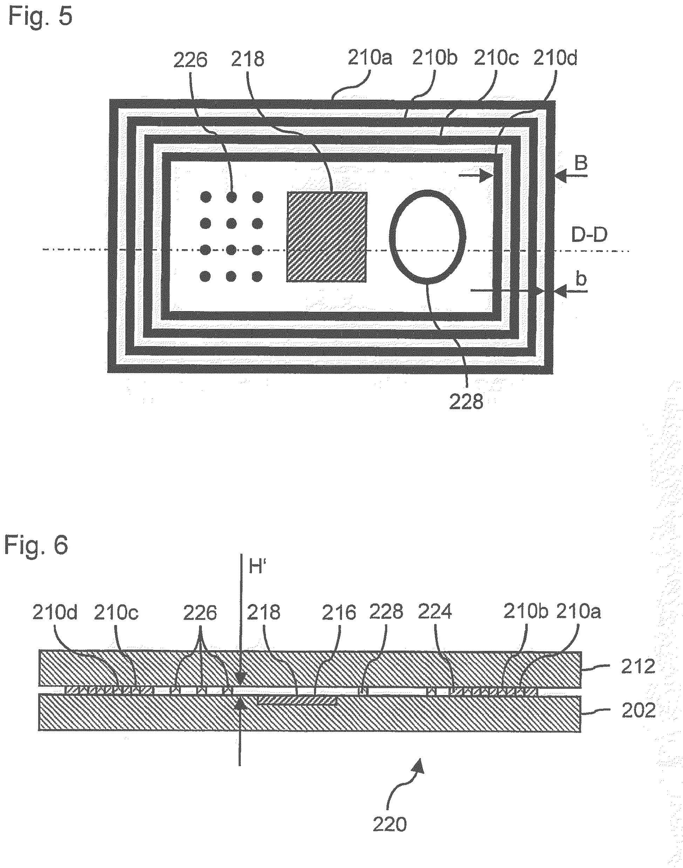

Bezugnehmend auf Fig. 5 sind innerhalb der Bondrahmen 210a bis 210d punktförmige Stützelemente 226 und ein Stützrahmen 228 zum Stützen des Decksubstrats 212 und zur Sicherung der Kavitätshöhe H' im Bereich des Bauelements 218 angeordnet.

Die Stützelemente 226 und der Stützrahmen 228 sind nicht mit dem Decksubstrat 212 verbunden, dieses liegt lediglich lose auf.

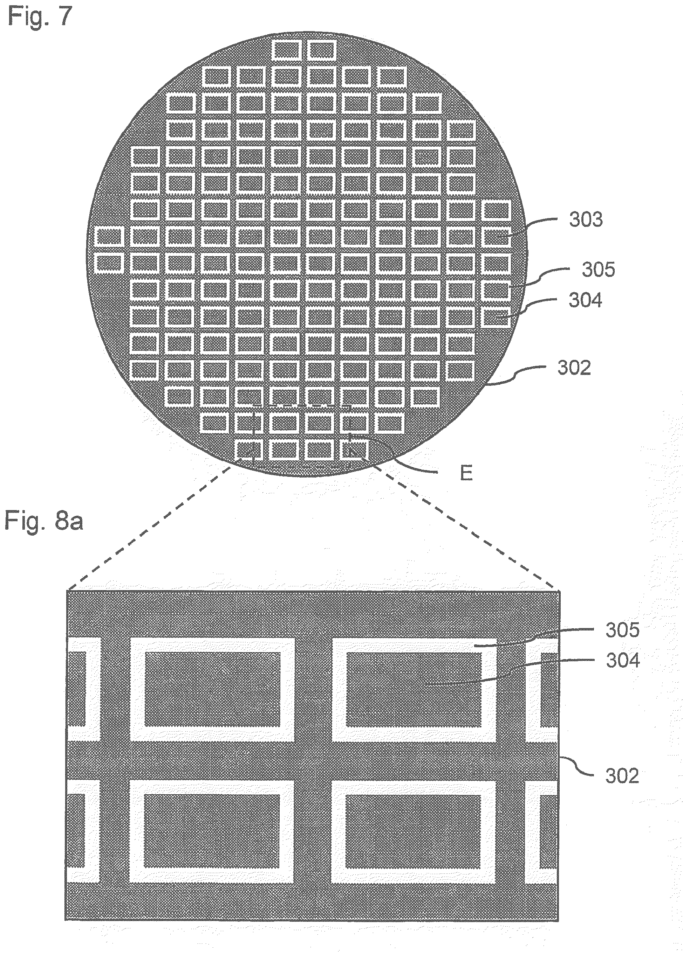

Bezugnehmend auf die Fig. 7 und 8a bis 8c wird im Folgenden ein Ausführungsbeispiel für mikro-optisch-elektromechanische Systeme (MOEMS) erläutert. Es wird ein strukturiertes Glassubstrat 302 als Decksubstrat zum Gehäusen von Imagesensoren im Waferverbund verwendet. Als "Abstandshalter" und sogenanntes "Sealing" Element wird eine Kavität im Gehäuse benötigt. Die Kavität ermöglicht beispielsweise die Funktion von mikrooptischen Elementen, wie Mikrolinsen und/oder Mikrospiegeln.

Wegen der optischen Funktion des Glassubstrats 302 versagen hier herkömmliche Verfahren oder können keine kostengünstige Lösung bieten. Subtraktive Verfahren wie Ätzen, Schleifen (sogenanntes Grinding), Ultraschallschwingläppen, Sandstrahlen oder Pressen vermag zwar grundsätzlich Kavitäten erzeugen, bei diesen würde jedoch die optisch hochwertige Innenfläche des Substrats 302 beeinträchtigt werden. Daher wird erfindungsgemäß die Bondingstruktur additiv aufgebracht.

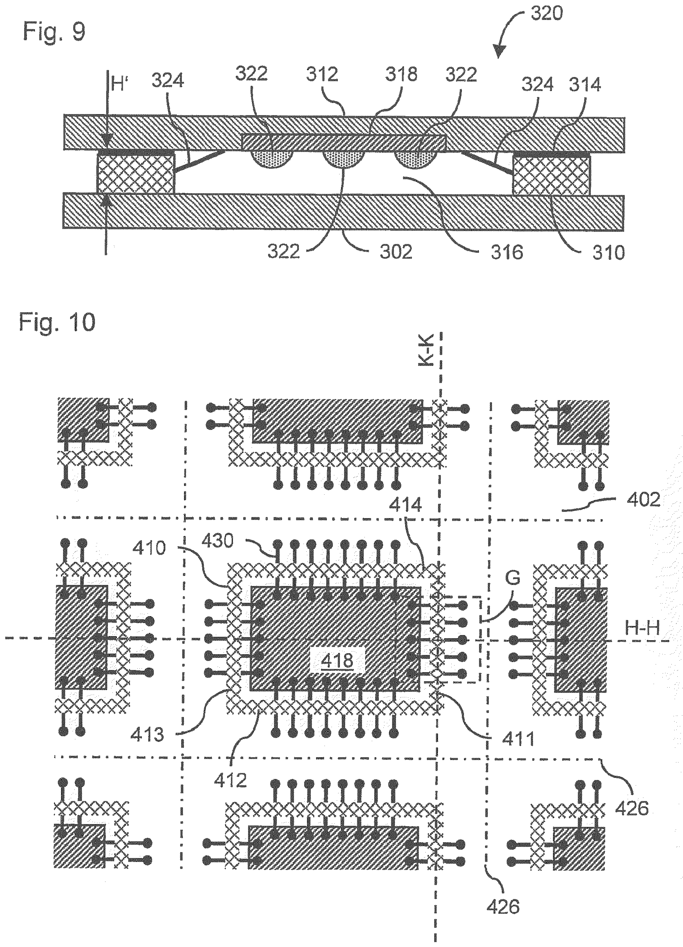

In Fig. 9 ist ein silikatisches Glassubstrat 302 mit einer Vielzahl von rechteckigen Fensterabschnitten 303 dargestellt, wobei jeder Fensterabschnitt 303 vollständig mit Fotolack 304 bedeckt ist. Das Substrat 302 ist in seinen thermo-mechanischen Eigenschaften an das zweite Substrat 312, einen Silizium-Wafer mit einem CMOS-Imagesensor 318 angepasst (vgl. Fig. 9). Das Substrat 302 wird mit dem Aufdampfglas 8329 strukturiert und dadurch mit einer Vielzahl von Rahmen der Höhe 5 µm versehen. In diesem Beispiel ist das Substrat 302 ein polierter Borofloat-33-Wafer (CTE: 3,3 ppm/K) mit einem Durchmesser von 150 mm und einer Dicke von 500 µm.

Der Fotolack 304 ist in Fig. 7 und 8a bereits strukturiert und weist um jeden Fensterabschnitt 303 eine rechteckige Aussparung 305 auf. Die Belackung umfasst z.B. AZ mit einer Dicke von 10 µm, wobei der Fotolack in einem sogenannten Maskaligner belichtet und entwickelt sowie anschließend mittels sogenanntem "Softcure" ausgehärtet ist. Dies ermöglicht einen späteren Lift-Off-Prozess z.B. in Aceton.

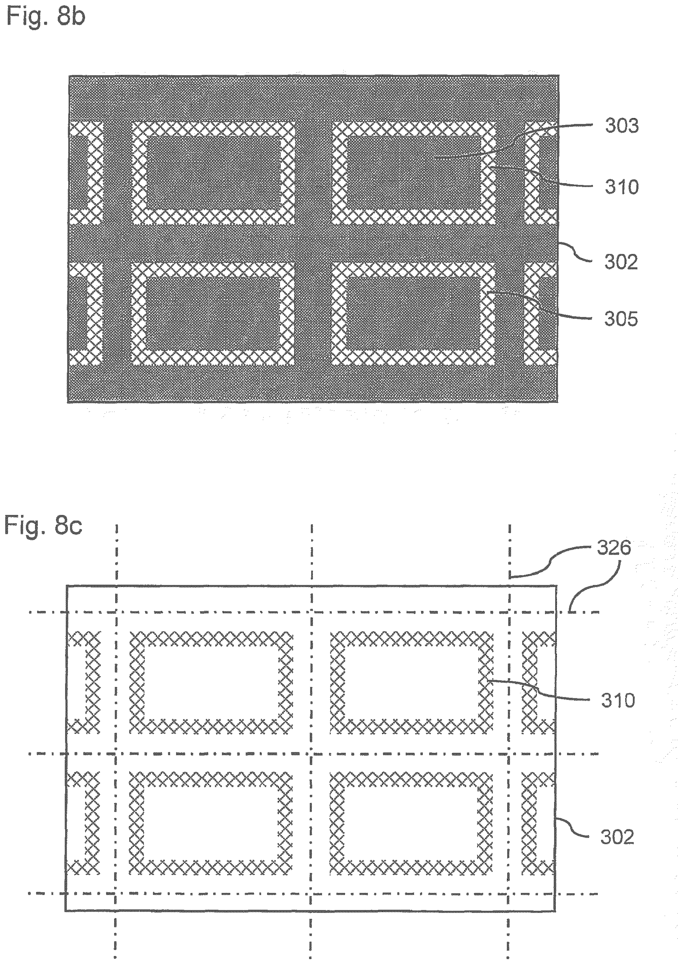

Fig. 8b zeigt die Waferoberfläche, welche in einem nachfolgenden Verfahrensschritt mit einer Glasschicht bedampft wurde. Das mit Photolack strukturierte Negativ-Abbild ist mit einer 5 µm dicken Glasschicht aus 8329 mit einer Abscheiderate von etwa 1 µm pro Minute bedampft. Die spätere Oberfläche oder der Fensterabschnitt 303 der Kavität wird durch die Fotolackmaske geschützt so dass das Aufdampfglas in diesen Bereichen nicht in Kontakt mit dem Substrat 302 kommen kann, sondern auf der Fotolackmaske abgeschieden wird. In den freien Stellen 305 wird das Glas 8329 unmittelbar auf dem Substrat 302 abgeschieden.

Nachfolgend werden die auf der Lackmaske befindlichen Bereiche der aufgedampften Glasschicht mittels Lift-Off entfernt. Hierzu wird der Fotolack in Aceton abgelöst. Das abgeschiedene Glas in den Bereichen 305 ohne Photomaske verbleibt auf dem Substrat 302 und bildet die gewünschte Struktur in Form einer Matrix aus Bondrahmen 310.

Fig. 8c zeigt den Waferausschnitt nach dem Lift-Off-Vefahrensschritt.

Bezug nehmend auf Fig. 9 wird der strukturierte Borofloat 33-Wafer 302 anschließend auf ein zweites Substrat 312, welches eine Vielzahl von Imagesensoren 318 aufweist, anodisch gebondet. Das Ergebnis ist somit eine Vielzahl von optoelektronischen Verbundelementen 320, welche auf Waferebene gehäust sind.

Abschließend werden die einzelnen Verbundelelemente 320 entlang von Sägespuren 326 durch Zersägen (dicing) getrennt. Ein solches einzelnes Verbundelement 320 mit dem optoelektronischen Bauelement in Form des Imagesensors 318 auf einem Halbleitersubstrat 312 ist in Fig. 9 in einem Schnitt dargestellt.

Auf dem Imagesensor 318 und innerhalb der hermetisch geschlossenen Kavität 316 sind über das Halbleitersubstrat oder den Wafer 312 erhabene, passive optische Bauelemente in Form von Linsen 322 angebracht. Ferner sind in der Kavität 316 zwei Mikrospiegel 324, welche ggf. beweglich sind, angeordnet.

Das transparente Borofloat 33-Substrat 302 ist mittels Bondstellen 314 auf den Bondrahmen 310, dessen Höhe H mit 5 µm größer als die Höhe der optischen Bauelemente 322 und 324 ist, anodisch gebondet. Somit ist ein hermetisch dichtes zumindest teilweise transparentes Gehäuse mit einer Kavitätshöhe von ebenfalls etwa 5 µm für den Imagesensor 318, die Mikrolinsen 322 und Mikrospiegel 324 geschaffen.

Aufgrund des erfindungsgemäßen Verfahrens bleibt die optische Funktion des Substratglases 302 im Bereich der Kavität 316 vollständig unbeeinträchtigt.

Die erfindungsgemäß erzeugten Rahmen haben den weiteren Vorteil, dass die für das Vereinzeln notwendige Sägespur 326 frei bleiben kann.

Es sind ferner folgende Variationen möglich:
Soll das Substrat 302 z.B. zum Legierungslöten oder zum anodischen Bonden mit einem weiteren Glassubstrat verbunden werden, so wird vor dem Lift-Off-Verfahrensschritt ein Bondlayer aufgebracht. Hierzu wird entweder mittels physical vapor deposition (PVD) oder chemical vapor deposition (CVD) eine Metallschicht als Bondlayer oder mittels CVD ein Polysilicon-Bondlayer abgeschieden. Auf diese Weise wird der Bondlayer beim Lift-Off in einem Arbeitsschritt mit dem Rahmen 310 strukturiert.

Das anodische Bonden kann in kontrollierter Atmosphäre mit vorbestimmter Gaszusammensetzung und vorbestimmtem Druck ausgeführt werden, insbesondere im Falle eines hermetischen Bondings, so dass die Kavitäten 316 eine kontrollierte und vorbestimmte Atmosphäre aufweisen.

Ferner können Gase, biologische oder und/oder sensorische Flüssigkeiten und/oder Partikel in den Kavitäten 316 eingeschlossen werden.

Bezugnehmend auf Fig. 10 ist Ausschnitt aus einem Silizium-Wafer 402 mit einer Vielzahl von Halbleiterbereichen 418 dargestellt. Die Halbleiterbereiche 418 sind mit Leiterbahnen 430 kontaktiert. Mittels des erfindungsgemäßen Verfahrens gemäß den in Fig. 1a bis 1d dargestellten Schritte ist jeweils ein Bondrahmen 410 über die zu einem Halbleiterbereich gehörigen Leiterbahnen aus Aluminium aufgedampft. Alternativ können die Leiterbahnen Gold, Wolfram oder Titan-Wolfram umfassen. Die Stege 411 bis 414, welchen den rechteckigen Bondrahmen 410 bilden, sind quer über den Leiterbahnen 430 angeordnet.

Auf diese Weise können insbesondere nicht anodisch bondbare Strukturen wie die Leiterbahnen 430 auf einem Substrat 402 durch den aufgedampften Bond- oder Glasrahmen 410 überdeckt werden. Es wird folglich eine hermetische Überdeckung, insbesondere eine hermetische Durchführung der Leiterbahnen 430 erzeugt. Nach dem Verbinden mit einem Decksubstrat und dem Zerteilen entlang der Sägelinien 426 entsteht eine Vielzahl von hermetisch gekapselten Chips mit außen liegenden Kontakten.

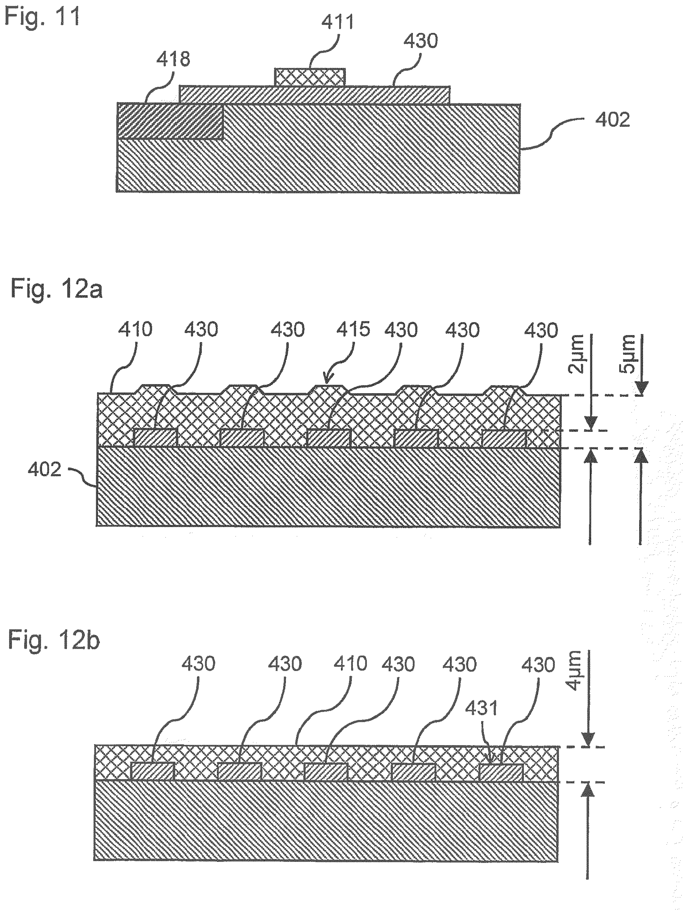

Fig. 11 zeigt eine Ausschnittsvergrößerung des Bereiches G in Fig. 10, geschnitten entlang der Linie H-H.

Fig. 12a zeigt eine Ausschnittsvergrößerung des Bereiches G in Fig. 10 geschnitten entlang der Linie K-K vor dem Verbinden mit dem Decksubstrat. Die Leiterbahnen 430 weisen in diesem Beispiel eine relativ große Dicke oder Höhe von 2 µm auf und verlaufen quer zur Blattebene. Durch die Dicke der Leiterbahnen 430 ist beim Aufdampfen eine unebene Plateaufläche 415 des Bondrahmens 410 entstanden.

Bezug nehmend auf Fig. 12b wird zum Ausgleich der stärkeren Topographie und zur Erzeugung einer geeigneten ebenen Bondrahmenplateaufläche 415 diese mittels eines CMP-Verfahrens planarisiert. Sie kann ferner gleichzeitig auch merklich, z.B. vom 5 µm auf 4 µm gedünnt werden. Entsprechend kann auch mit jedem anderen nicht planaren Substrat verfahren werden. Es ist ferner denkbar den Bondrahmen bis jenseits der Oberfläche 431 der Leiterbahnen 430 abzutragen, so dass die Leiterbahnen 430 von oben kontaktierbar sind (nicht dargestellt).

Bei einer geringeren Dicke der Leiterbahnen von typischerweise 400 nm kann gegebenenfalls auf eine Planarisierung verzichtet werden.

Wird zur Überdeckung ein anodisch bondbares Glas, wie in diesem Beispiel 8329 verwendet, kann der Rahmen wiederum anodisch mit einem Decksubstrat gebonded werden.

Im Folgenden sind Ergebnisse verschiedener Untersuchungen von aufgedampften Glasschichten aus dem Glas 8329 dargestellt.

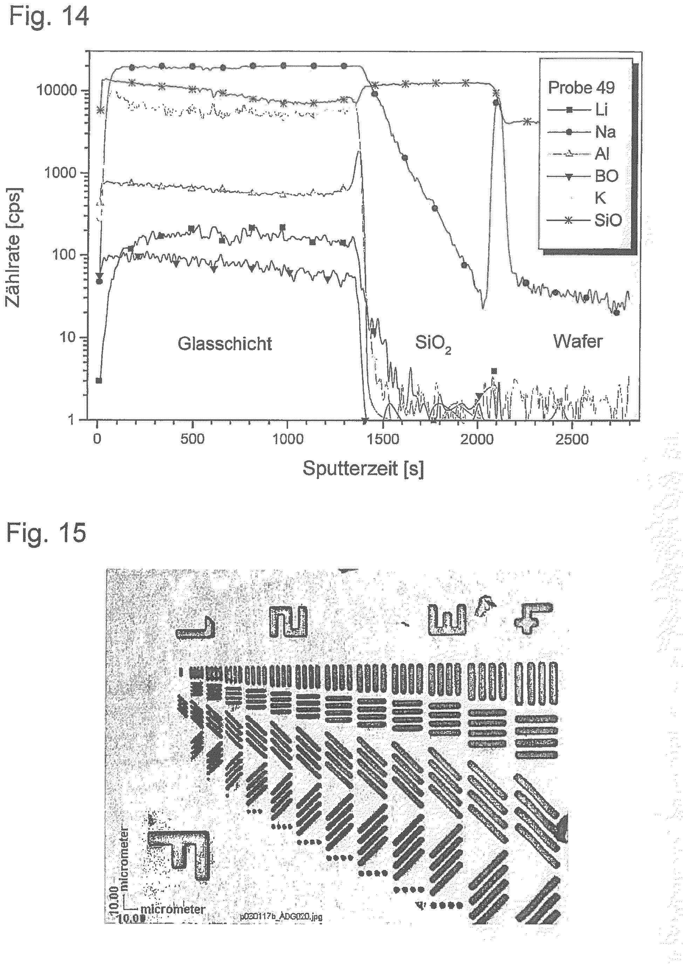

Bezugnehmend auf Fig. 14 sind die Ergebnisse einer TOF-SIMS-Messung gezeigt, wobei die Zählrate als Funktion der Sputterzeit aufgetragen ist. Die Messung charakterisiert den Verlauf der Elementkonzentrationen des Glasrahmens. Es wurde eine Dickenkonstanz für den Glasrahmen von < 1 % der Schichtdicke ermittelt.

Bezugnehmend auf Fig. 15 sind aufgedampfte und fotolackstrukturierte Glasstrukturen des Glases 8329 nach dem Lift-Off dargestellt.

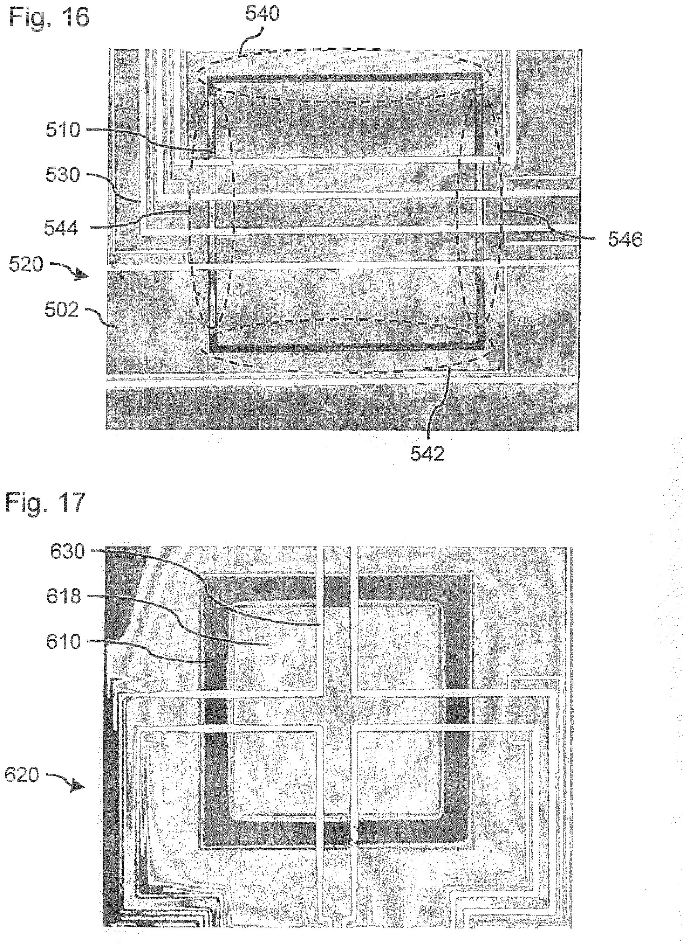

Bezugnehmend auf Fig. 16 ist ein Verbundelements 520 mit einem Borofloat-33-Substrat 502 und Leiterbahnen 530 und darüber gedampftem Glasrahmen 510, ähnlich dem fünften Ausführungsbeispiel gezeigt.

Die Dicke der Leiterbahnen 530 beträgt 200 nm und die Dicke des Glasrahmens 510 beträgt 4 µm. Bei diesem sechsten Ausführungsbeispiel ist das Decksubstrat ohne Planarisierungsschritt anodisch aufgebondet.

Es ist deutlich zu sehen, dass eine Bondverbindung lediglich in den Bereichen 540 und 542 besteht, während in den Bereichen 544 und 546 in der Nähe der Leiterbahnen 530 keine Bondverbindung hergestellt werden konnte. Das mangelhafte Bonding ist wohl auf die durch die Leiterbahnen verursachten Unebenheit der Oberfläche oder Plateaufläche des Glasrahmens 510 zurückzuführen.

Bezugnehmend auf Fig. 17 ist ein ähnlich dem Verbundelement 520 aufgebautes Verbundelements 620 gezeigt. Bei dem Verbundelement 620 wurde der Glasrahmen 610 vor dem anodischen Bonden planarisiert. Der Glasrahmen 610 ist mit einer Dicke von 4 µm aufgedampft und wurde auf etwa 2 µm herunterpoliert. Die Dicke der Leiterbahnen 630 beträgt ebenfalls 200 nm.

Es ist deutlich zu sehen, dass die gesamte Oberfläche des Glasrahmens 610 gebondet ist, so dass ein hermetischer Abschluss der Kavität 616 gebildet wurde. Der Glasrahmen 610 weist eine Stegbreite von 300 pm und eine Größe von 3 mm x 3 mm auf.

Darüber hinaus wurden Dichtigkeitstests der Glasschicht 8329 wie folgt durchgeführt.

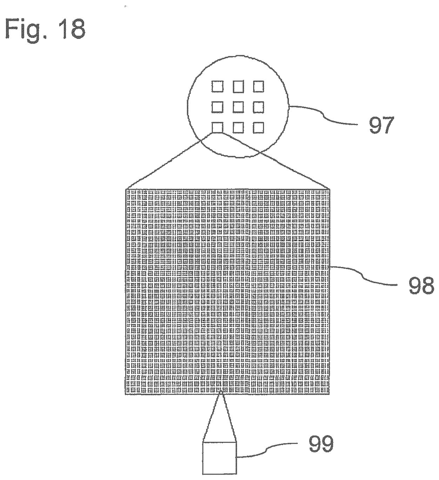

Es wurde ein Silizium-Wafer mit einer Ätzstopmaske versehen. Wie in Fig. 18 dargestellt ist, wurde der Wafer 97 in neun Lochareale 98 (1 cm x 1 cm) untergliedert. Der Einzellochabstand in den Arealen wurde von Reihe zu Reihe wie folgt verändert.
1. Reihe: 1mm Lochabstand
2. Reihe: 0,5mm Lochabstand
3. Reihe: 0,2mm Lochabstand
   Alle quadratischen Löcher 99 besitzen eine Kantenlänge von 15 µm.

Nach Beschichten der nicht strukturierten Waferrückseite mit einer 8 µm (Probe A) bzw. 18 µm (Probe B) Schicht aus dem Glas 8329, wurde anschließend der Wafer in den Lochflächen bis zum Glas trockengeätzt. Der Erfolg des Ätzens konnte gut im Durchlichtmikroskop beobachtet werden.

Es sind Leckraten von zumindest < 10⁻⁷ mbar l/sec erreichbar. Für dieses Ausführungsbeispiel ergab eine Helium-Leckmessung eine Leckrate von < 10⁻⁸ mbar l/sec der Glasschicht und damit der hermetischen Kavität.

Erstaunlich ist auch die hohe Festigkeit der Glasschichtbereiche trotz erheblicher Durchwölbung des Wafers während der Messung im jeweiligen Messareal. Auch nach einer Temperung bei 200°C stellte sich keine Veränderung der Glasstruktur ein.

Ferner wurden Beständigkeitsmessungen des Glasrahmens nach DIN/ISO durchgeführt. Die Ergebnisse sind in Tabelle 1 wiedergegeben.

**Tabelle 1:**

| Probenbezeichnung: | **8329** | | |
|---|---|---|---|
| **Wasser DIN ISO 719** Klasse | Verbrauch HCl [ml/g] | Äquivalent Na₂O [µg/g] | **Bemerkungen** |
| **HGB 1** | **0,011** | 3 | **keine** |

| **Säure DIN 12116** Klasse | Abtrag [mg/dm²] | Gesamt-Oberfläche [cm²] | Bemerkungen/ sichtbare Veränderungen |
|---|---|---|---|
| **1 W Als Werkstoff** | **0,4** | **2 x 40** | **unverändert** |

| **Lauge DIN ISO 695** Klasse | Abtrag [mg/dm²] | Gesamt-Oberfläche [cm²] | Bemerkungen/ sichtbare Veränderungen |
|---|---|---|---|
| **A2** Als Werkstoff | **122** | **2 x 14** | **unverändert** |

Es ist dem Fachmann ersichtlich, dass die vorstehend beschriebenen Ausführungsformen beispielhaft zu verstehen sind, und die Erfindung nicht auf diese beschränkt ist.

## Patentansprüche

1. Verfahren zum Verbinden von zumindest zwei Substraten mit elektrischen, halbleitenden, mechanischen und/oder optischen Bauelementen, umfassend die Schritte Bereitstellen eines ersten Substrats (2, 102, 302, 402, 502),
Erzeugen eines Verbindungselements in Form eines Rahmens (10, 310, 410, 510, 610) aus Glas auf einer ersten Oberfläche des ersten Substrats (2, 102, 302, 402, 502), wobei Glas aufgedampft wird und das Verbindungselement sich beim Abscheiden mit dem ersten Substrat (2, 102, 302, 402, 502) verbindet, und wobei auf der ersten Oberfläche des ersten Substrats (2, 102, 302, 402, 502) Leiterbahnen (430, 530) angeordnet sind und das Verbindungselement derart auf die erste Oberfläche aufgedampft wird, dass die Leiterbahnen (430, 530) zumindest teilweise abgedeckt werden und sich die Leiterbahnen (430, 530) lateral oder vertikal durch das Verbindungselement hindurch erstrecken und hermetisch durch den Rahmen (10, 310, 410, 510, 610) durchgeführt sind,
Bereitstellen eines zweiten Substrats (12, 212, 312) und
Verbinden des ersten und zweiten Substrats mittels des Verbindungselements, wobei zwischen dem ersten und zweiten Substrat (12, 212, 312) und innerhalb des Rahmens (10, 310, 410, 510, 610) eine Kavität (16, 316, 616) gebildet wird, welche hermetisch abgeschlossen ist, und wobei das erste oder zweite Substrat ein Glassubstrat ist.

2. Verfahren nach Anspruch 1,
wobei innerhalb des Verbindungselements ein oder mehrere Stützelemente (226) auf der ersten Oberfläche des ersten Substrats (2, 102, 302, 402, 502) erzeugt werden.

3. Verfahren nach einem der vorstehenden Ansprüche,
wobei als Verbindungselement eine Mehrzahl von ineinander geschachtelten Rahmen (110a -110d) aufgedampft wird.

4. Verfahren nach einem der vorstehenden Ansprüche,
wobei als Verbindungselement eine Glasschicht (6) durch eine Maske aufgedampft und
strukturiert wird.

5. Verfahren nach einem der vorstehenden Ansprüche,
wobei das Verbindungselement mittels Lift-off-Technik strukturiert wird.

6. Verfahren nach einem der vorstehenden Ansprüche,
wobei das Verbindungselement und das zweite Substrat (12, 212, 312) verklebt, verlötet oder gebondet werden.

7. Verfahren nach einem der vorstehenden Ansprüche,
wobei das Verbindungselement und das zweite Substrat (12, 212, 312) mittels anodischem Bonding, Fusion Bonding, Sol-Gel-Bonding oder Low-Temperature-Bonding verbunden werden.

8. Verfahren nach einem der vorstehenden Ansprüche,
wobei
das erste und zweite Substrat einen ersten bzw. zweiten Wafer (302, 312) umfasst, auf der ersten Oberfläche des ersten Wafers (302) eine Vielzahl von lateral benachbarten Verbindungselementen erzeugt werden und
nach dem Verbinden des ersten und zweiten Wafers (302, 312) zu einem Waferverbund, der Waferverbund in einzelne Chips zerteilt wird.

9. Verfahren nach einem der vorstehenden Ansprüche,
wobei das Verbindungselement nach dem Erzeugen auf der ersten Oberfläche des ersten Substrats (2, 102, 302, 402, 502) planarisiert wird.

10. Verfahren nach einem der vorstehenden Ansprüche,
wobei Justierelemente auf der ersten oder einer zweiten Oberfläche des ersten Substrats (2, 102, 302, 402, 502) erzeugt werden, wobei die zweite Oberfläche der ersten Oberfläche gegenüberliegt.

11. Verfahren nach einem der vorstehenden Ansprüche,
wobei eine Vielzahl von Substraten zu einem Stapel verbunden werden.

12. Verbundelement (20) mit elektrischen, elektronischen, halbleitenden, mechanischen und/oder optischen Bauelementen, umfassend
ein erstes Substrat (2, 102, 302, 402, 502),
ein Verbindungselement in Form eines Rahmens (10, 310, 410, 510, 610) aus einer Glasschicht (6) auf einer ersten Oberfläche des ersten Substrats (2, 102, 302, 402, 502),
ein zweites Substrat (12, 212, 312),
wobei das erste und zweite Substrat mittels des Verbindungselements verbunden sind, und wobei das erste oder das zweite Substrat ein Glassubstrat ist, und wobei auf der ersten Oberfläche des ersten Substrats (2, 102, 302, 402, 502) Leiterbahnen (430, 530) angeordnet sind und das Verbindungselement derart auf der ersten Oberfläche angeordnet ist, dass die Leiterbahnen (430, 530) zumindest teilweise abgedeckt werden und sich die Leiterbahnen (430, 530) lateral oder vertikal durch das Verbindungselement hindurch erstrecken und hermetisch durch den Rahmen (10, 310, 410, 510, 610) durchgeführt sind, wobei eine hermetisch abgeschlossene Kavität (16, 316, 616) zwischen dem ersten und zweiten Substrat gebildet wird.

13. Verbundelement (20) nach vorstehendem Anspruch,
wobei innerhalb des Verbindungselements ein oder mehrere Stützelemente (226) auf der ersten Oberfläche des ersten Substrats (2, 102, 302, 402, 502) angeordnet sind.

14. Verbundelement (20) nach einem der Ansprüche 12 oder 13, wobei
das erste und zweite Substrat einen ersten bzw. zweiten Wafer (302, 312) umfasst,
auf der ersten Oberfläche des ersten Wafers (302) eine Vielzahl von lateral benachbarten Verbindungselementen angeordnet sind und
die Verbindungselemente mit einer Oberfläche des zweiten Substrats (12, 212, 312) verbunden sind.

15. Verbundelement (20) nach einem der Ansprüche 12 bis 14,
wobei Justierelemente auf der ersten oder einer zweiten Oberfläche des ersten Substrats (2, 102, 302, 402, 502) angeordnet sind, wobei die zweite Oberfläche der ersten Oberfläche gegenüberliegt.

16. Stapel-Verbundelement, umfassend Vielzahl von Verbundelementen (20) nach einem der Ansprüche 12 bis 15, welche miteinander verbunden sind.

## Claims

1. A method for connecting at least two substrates which comprise electrical, semiconducting, mechanical and/or optical components, comprising the steps of
providing a first substrate (2, 102, 302, 402, 502);
producing a joining element in the form of a frame (10, 310, 410, 510, 610) made of glass on a first surface of the first substrate (2, 102, 302, 402, 502), wherein glass is vapour-deposited and the joining element bonds to the first substrate (2, 102, 302, 402, 502) during deposition, and wherein conductive traces (430, 530) are disposed on the first surface of the first substrate (2, 102, 302, 402, 502) and the joining element is vapour-deposited onto the first surface so as to at least partially cover the conductive traces (430, 530) and so that the conductive traces (430, 530) extend through the joining element laterally or vertically and hermetically extend through the frame (10, 310, 410, 510, 610);
providing a second substrate (12, 212, 312); and
connecting the first and second substrates by the joining element thereby forming a cavity (16, 316, 616) between the first and second substrates (12, 212, 312) and inside the frame (10, 310, 410, 510, 610), which cavity is hermetically sealed; and wherein the first or second substrate is a glass substrate.

2. The method according to claim 1,
wherein one or more support elements (226) are produced on the first surface of the first substrate (2, 102, 302, 402, 502) inside the joining element.

3. The method according to any one of the preceding claims,
wherein a plurality of nested frames (110a -110d) is vapour-deposited as the joining element.

4. The method according to any one of the preceding claims,
wherein a glass layer (6) is vapour-deposited and patterned through a mask as the joining element.

5. The method according to any one of the preceding claims,
wherein the joining element is patterned by a lift-off technique.

6. The method according to any one of the preceding claims,
wherein the joining element and the second substrate (12, 212, 312) are glued, soldered, or bonded to one another.

7. The method according to any one of the preceding claims,
wherein the joining element and the second substrate (12, 212, 312) are connected by anodic bonding, fusion bonding, sol-gel bonding, or low-temperature bonding.

8. The method according to any one of the preceding claims, wherein
the first and second substrates comprise first and second wafers (302, 312), respectively;
a plurality of laterally adjacent joining elements are produced on the first surface of the first wafer (302); and
after the first and second wafers (302, 312) have been connected to form a composite wafer, the composite wafer is separated into individual dies.

9. The method according to any one of the preceding claims,
wherein after having been produced on the first surface of the first substrate (2, 102, 302, 402, 502), the joining element is planarized.

10. The method according to any one of the preceding claims,
wherein adjustment elements are produced on the first or on a second surface of the first substrate (2, 102, 302, 402, 502), the second surface being opposite the first surface.

11. The method according to any one of the preceding claims,
wherein a plurality of substrates are connected to form a stack.

12. A composite element (20) including electrical, electronic, semiconducting, mechanical, and/or optical components, comprising
a first substrate (2, 102, 302, 402, 502);
a joining element in the form of a frame (10, 310, 410, 510, 610) made of a glass layer (6) on a first surface of the first substrate (2, 102, 302, 402, 502);
a second substrate (12, 212, 312);
wherein the first and second substrates are connected by the joining element, and wherein the first or the second substrate is a glass substrate, and wherein conductive traces (430, 530) are disposed on the first surface of the first substrate (2, 102, 302, 402, 502) and the joining element is disposed on the first surface so as to at least partially cover the conductive traces (430, 530) and so that the conductive traces (430, 530) extend through the joining element laterally or vertically and hermetically extend through the frame (10, 310, 410, 510, 610), whereby a hermetically sealed cavity (16, 316, 616) is formed between the first and second substrates,

13. The composite element (20) according to the preceding claim,
wherein one or more support elements (226) are disposed on the first surface of the first substrate (2, 102, 302, 402, 502) inside the joining element.

14. The composite element (20) according to any one of claims 12 or 13, wherein
the first and second substrates comprise first and second wafers (302, 312), respectively;
a plurality of laterally adjacent joining elements are arranged on the first surface of the first wafer (302); and
the joining elements are connected to a surface of the second substrate (12, 212, 312).

15. The composite element (20) according to any one of claims 12 to 14,
wherein adjustment elements are disposed on the first or on a second surface of the first substrate (2, 102, 302, 402, 502), the second surface being opposite the first surface.

16. A stacked composite element, comprising a plurality of composite elements (20) according to any one of claims 12 to 15, which are connected to one another.

## Revendications

1. Procédé de liaison d'au moins deux substrats portant des composants électriques, semi-conducteurs, mécaniques et/ou optiques, comprenant les étapes suivantes :
mise à disposition d'un premier substrat (2, 102, 302, 402, 502),
réalisation d'un élément de liaison sous la forme d'un cadre (10, 310, 410, 510, 610) en verre, sur une première surface du premier substrat (2, 102, 302, 402, 502), avec dépôt de verre en phase vapeur et liaison de l'élément de liaison avec le premier substrat (2, 102, 302, 402, 502) lors de la séparation, des pistes conductrices (430, 530) étant disposées sur la première surface du premier substrat (2, 102, 302, 402, 502), et l'élément de liaison étant déposé par phase vapeur sur la première surface de telle manière que les pistes conductrices (430, 530) soient recouvertes au moins en partie et les pistes conductrices (430, 530) s'étendent latéralement ou verticalement à travers l'élément de liaison et passent de manière hermétique à travers le cadre (10, 310, 410, 510, 610),
mise à disposition d'un deuxième substrat (12, 212, 312), et
liaison du premier et du deuxième substrat au moyen de l'élément de liaison, sachant qu'une cavité (16, 316, 616) hermétiquement fermée est formée entre le premier et le deuxième substrat (12, 212, 312) et à l'intérieur du cadre (10, 310, 410, 510, 610), et que le premier ou le deuxième substrat est un substrat en verre.

2. Procédé selon la revendication 1, selon lequel un ou plusieurs éléments de support (226) sont réalisés à l'intérieur de l'élément de liaison, sur la première surface du premier substrat (2, 102, 302, 402, 502).

3. Procédé selon l'une des revendications précédentes, selon lequel une pluralité de cadres (110a à 110d) emboîtés les uns dans les autres sont déposés en phase vapeur, en tant qu'élément de liaison.

4. Procédé selon l'une des revendications précédentes, selon lequel une couche de verre (6), en tant qu'élément de liaison, est déposée en phase vapeur à travers un masque et est structurée.

5. Procédé selon l'une des revendications précédentes, selon lequel l'élément de liaison est structuré à l'aide de la technique lift-off.

6. Procédé selon l'une des revendications précédentes, selon lequel l'élément de liaison et le deuxième substrat (12, 212, 312) sont collés, brasés ou liés par métallisation.

7. Procédé selon l'une des revendications précédentes, selon lequel l'élément de liaison et le deuxième substrat (12, 212, 312) sont reliés par liaison anodique, liaison par fusion, liaison sol-gel ou liaison basse température.

8. Procédé selon l'une des revendications précédentes, selon lequel
le premier et le deuxième substrat comportent respectivement une première et une deuxième plaquette (302, 312),
une pluralité d'éléments de liaison latéralement adjacents sont réalisés sur la première surface de la première plaquette (302), et
après la liaison de la première et de la deuxième plaquette (302, 312) pour former une plaquette composite, ladite plaquette composite est divisée en microplaquettes individuelles.

9. Procédé selon l'une des revendications précédentes, selon lequel l'élément de liaison est planarisé après la réalisation sur la première surface du premier substrat (2, 102, 302, 402, 502).

10. Procédé selon l'une des revendications précédentes, selon lequel des éléments d'ajustage sont réalisés sur la première ou sur une deuxième surface du premier substrat (2, 102, 302, 402, 502), la deuxième surface se situant en vis-à-vis de la première surface.

11. Procédé selon l'une des revendications précédentes, selon lequel une pluralité de substrats sont reliés pour former une pile.

12. Elément composite (20) portant des composants électriques, électroniques, semi-conducteurs, mécaniques et/ou optiques, compre-nant
un premier substrat (2, 102, 302, 402, 502),
un élément de liaison sous forme de cadre (10, 310, 410, 510, 610) constitué d'une couche de verre (6) sur une première surface du premier substrat (2, 102, 302, 402, 502),
le premier et le deuxième substrat étant reliés au moyen de l'élément de liaison, et le premier ou le deuxième substrat étant un substrat en verre, et des pistes conductrices (430, 530) étant disposées sur la première surface du premier substrat (2, 102, 302, 402, 502), et l'élément de liaison étant disposé sur la première surface de manière à ce que les pistes conductrices (430, 530) soient recouvertes au moins en partie et les pistes conductrices (430, 530) s'étendent latéralement ou verticalement à travers l'élément de liaison et passent de façon hermétique à travers le cadre (10, 310, 410, 510, 610), une cavité (16, 316, 616) hermétiquement fermée étant formée entre le premier et le deuxième substrat.

13. Elément composite (20) selon la revendication précédente, avec lequel un ou plusieurs éléments de support (226) sont réalisés à l'intérieur de l'élément de liaison, sur la première surface du premier substrat (2, 102, 302, 402, 502).

14. Elément composite (20) selon l'une des revendications 12 ou 13, avec lequel
le premier et le deuxième substrat comportent respectivement une première et une deuxième plaquette (302, 312),
une pluralité d'éléments de liaison latéralement adjacents sont disposés sur la première surface de la première plaquette (302), et
les éléments de liaison sont reliés à une surface du deuxième substrat (12, 212, 312).

15. Elément composite (20) selon l'une des revendications 12 à 14, avec lequel des éléments d'ajustage sont disposés sur la première ou sur une deuxième surface du premier substrat (2, 102, 302, 402, 502), la deuxième surface se situant en vis-à-vis de la première surface.

16. Elément composite empilé, comprenant une pluralité d'éléments composites (20) selon l'une des revendications 12 à 15, qui sont reliés les uns aux autres.
